# EUROPEAN PATENT APPLICATION

(11) **EP 3 334 258 A1**
(43) Date of publication of application: **13.06.2018**
(21) Application number: 17190322.2
(22) Date of filing: 11.09.2017
(51) Int. Cl.: H05K 1/02, H05K 3/28, H05K 7/20, H01L 23/552, H05K 3/34

(54) **CIRCUIT BOARD DEVICE**

(30) Priority: 07.12.2016 JP 2016237622
(71) Applicant: KABUSHIKI KAISHA TOSHIBA, Minato-ku Tokyo 105-8001 (JP); Toshiba Infrastructure Systems & Solutions Corporation, Kawasaki-shi, Kanagawa 212-8585 (JP)
(72) Inventor: Satake, Yoshiaki, Kawasaki, 212-8585 (JP); Tamai, Shinji, Kawasaki, 212-8585 (JP)
(74) Representative: Hoffmann Eitle

(57) **Abstract**

A circuit board device of the embodiment includes: a mount board (10) having an electronic component (12) and a printed circuit board (11) having at least one surface where the electronic component is mounted; a heat path (40) arranged to a position facing the mount surface of the mount board, a sheet (30) arranged on the mount surface, and a resin portion (20) arranged between the sheet and the heat path. A cavity (D) surrounded by the sheet and the mount surface is formed in a step portion between the electronic component and the printed circuit board.

## Description

### FIELD

Embodiments described herein relate generally to a circuit board device.

### BACKGROUND

In a case where an electronic component generating a large amount of heat is mounted on a board, it is necessary to efficiently transfer heat of the electronic component to a heat path. It is known that thermal conductivity of the air is significantly low. If there is a space between the board and the heat path, the heat is not efficiently transferred from the electronic component to the heat path. As one of methods of efficiently transferring heat of the electronic component to the heat path, a method of arranging resin between the board and the heat path is known in the art.

### DESCRIPTION OF THE DRAWINGS

FIG 1 is a cross-sectional view illustrating a circuit board device according to a first embodiment;
FIG 2 is a cross-sectional view illustrating a mount board provided in the circuit board device according to the first embodiment;
FIG 3A is a diagram illustrating a process of manufacturing the circuit board device;
FIG 3B is a diagram illustrating a process of manufacturing the circuit board device;
FIG 3C is a diagram illustrating a process of manufacturing the circuit board device;
FIG 4 is a cross-sectional view illustrating a circuit board device in which a sheet is not employed;
FIG 5 is a diagram illustrating a situation in which a void is generated between the sheet and the mount board;
FIG 6 is a cross-sectional view illustrating a circuit board device according to a second embodiment;
FIG 7 is a cross-sectional view illustrating a mount board provided in the circuit board device according to the second embodiment;
FIG 8 is a cross-sectional view illustrating a circuit board device according to a third embodiment;
FIG 9 is a bottom view illustrating a sheet provided in the circuit board device according to the third embodiment;
FIG 10 is a cross-sectional view illustrating a circuit board device according to a fourth embodiment;
FIG 11 is a diagram illustrating a modification of the circuit board device according to the fourth embodiment;
FIG 12 is a diagram illustrating a modification of the circuit board device according to the fourth embodiment;
FIG 13 is a cross-sectional view illustrating a circuit board device according to a fifth embodiment;
FIG 14 is a cross-sectional view illustrating resin provided in the circuit board device according to the fifth embodiment;
FIG 15 is a diagram illustrating a modification of the circuit board device according to the fifth embodiment;
FIG 16 is a diagram illustrating a modification of the circuit board device according to the fifth embodiment;
FIG 17 is a cross-sectional view illustrating a circuit board device according to a sixth embodiment;
FIG 18 is a diagram illustrating a sheet provided in the circuit board device according to the sixth embodiment as seen from the mount board side;
FIG 19A is an enlarged cross-sectional view illustrating the vicinity of the sheet while an electronic component provided in the circuit board device according to the sixth embodiment is not heated;
FIG 19B is an enlarged cross-sectional view illustrating the vicinity of the sheet while an electronic component provided in the circuit board device according to the sixth embodiment is heated;
FIG 20A is a diagram illustrating a modification of the circuit board device according to the sixth embodiment;
FIG 20B is a diagram illustrating a modification of the circuit board device according to the sixth embodiment;
FIG 21A is an enlarged cross-sectional view illustrating the vicinity of the resin portion while an electronic component provided in the circuit board device according to a seventh embodiment is not heated;
FIG 21B is an enlarged cross-sectional view illustrating the vicinity of the resin portion while an electronic component provided in the circuit board device according to the seventh embodiment is heated;
FIG 22 is a diagram illustrating a modification of the circuit board device according to the fifth embodiment;
FIG 23 is a diagram illustrating a modification of the circuit board device according to the fifth embodiment; and
FIG 24 is a diagram illustrating a modification of the circuit board device according to the fourth embodiment.

### DETAILED DESCRIPTION

Embodiments of the present invention will now be described with reference to the accompanying drawings. Note that like reference numerals denote like elements throughout the drawings.

### First Embodiment

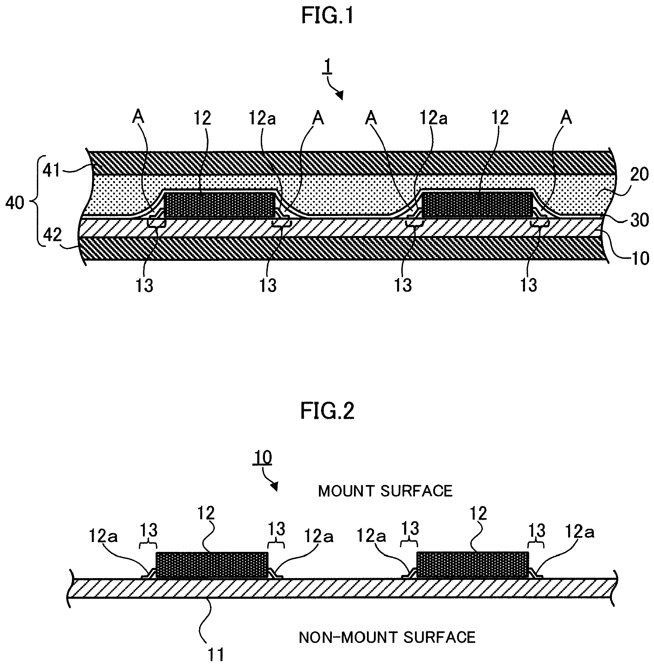

A circuit board device according to a first embodiment is a circuit board device provided with a heat path that transfers heat of an electronic component mounted on a board to an external or other component(s). FIG 1 is a diagram illustrating the circuit board device 1 according to the first embodiment. The circuit board device 1 includes a mount board 10, a resin portion 20, a sheet 30, and a heat path 40. The heat path 40 includes a pair of heat paths 41 and 42.

The mount board 10 is a board on which electronic components are mounted. FIG 2 illustrates only the mount board 10 removed from the circuit board device 1. The mount board 10 is a single-sided mount board having one surface serving as a mount surface and the other surface serving as a non-mount surface. The mount surface is a surface where the electronic components are mounted. The non-mount surface is a surface where no electronic component is mounted. The mount board 10 includes a printed circuit board 11 and electronic components 12.

The printed circuit board 11 is a printed circuit board on which a conductive pattern formed of a copper foil or the like is provided on a plate-like insulation substrate. A thin insulation layer formed of epoxy resin or the like is laminated on a surface of the pattern. The printed circuit board 11 is formed of an insulation material having high thermal conductivity in order to efficiently transfer the heat of the electronic components 12 to the heat path 42. For example, the printed circuit board 11 is formed of a high thermal conductive insulation substrate such as a ceramic substrate or a metal-based substrate. The metal-based substrate is a substrate formed of a high thermal conductive metal such as aluminum or copper. The metal-based substrate obtains an insulation property with resin (for example, epoxy resin to which an inorganic filler is added).

Note that the insulation substrate of the printed circuit board 11 is not limited to a high thermal conductive substrate. The insulation substrate of the printed circuit board 11 may be formed of a paper-epoxy substrate obtained by impregnating epoxy resin into a paper sheet, a glass-epoxy substrate obtained by impregnating epoxy resin into glass fiber fabrics, or the like. Note that, in order to efficiently transfer the heat of the electronic components 12 to the heat path 42, a through-hole penetrating through the printed circuit board 11 may be formed in a portion of the printed circuit board 11 where the electronic components are arranged. A high thermal conductive metal (such as copper) may be filled in the through-hole.

The electronic components 12 include a resistor, a capacitor, a semiconductor package, and the like. In many cases, a semiconductor package having a plurality of terminals protruding from lateral sides is mounted on the board. For example, the electronic component 12 is a small-outline package (SOP) type or a quad flat package (QFP) type semiconductor package. The SOP type semiconductor package is a package in which terminals protrude from both opposite sides of the package. The QFP type semiconductor package is a package in which terminals protrude from all of four lateral sides of the package. FIG 2 illustrates a QFP type semiconductor package as an example of the electronic component 12. In the following description, the semiconductor package having terminals protruding from the lateral sides will be referred to as a "lateral-projecting type semiconductor package."

In the case of the lateral-projecting type semiconductor package, the terminals 12a protrude from the lateral sides of the semiconductor package. Therefore, a conductor exposure portion 13 is formed in the vicinity of the terminal 12a. The conductor exposure portion is a portion of the mount surface of the mount board 10 where a conductor is exposed to the board surface without being insulated. In addition to the vicinity of the terminal of the lateral-projecting type semiconductor package, for example, a land formed on a surface of the mount board 10 also serves as a conductor exposure portion.

Returning to FIG 1, the resin portion 20 is formed of resin for transferring the heat of the electronic components 12 to the heat path 41. The resin portion 20 is formed of high heat resistant resin such as polybutylene terephthalate (PBT) or polyphenylene sulfide (PPS). The resin portion 20 is placed between the mount board 10 and the heat path 41. The sheet 30 is placed between the resin portion 20 and the mount board 10. The resin portion 20 does not directly make contact with the mount board 10. The resin portion 20 indirectly makes contact with the mount board 10 by interposing the sheet 30. The resin portion 20 is fixed between the sheet 30 and the heat path 41, for example, by injecting resin molten by heat onto the sheet 30 and solidifying the molten resin.

Note that the heat conductivity of the resin portion 20 may be improved by mixing metal powder (such as powder of high thermal conductive metal such as copper, iron, and aluminum). As a result, it is possible to more efficiently transfer the heat of the electronic component 12 to the heat path 41. Note that the resin mixed with metal powder has conductivity in many cases. In a case where metal powder is mixed with the resin portion 20, the conductor exposure portions 13 may electrically connected to each other through the resin portion 20. Therefore, the sheet 30 is formed of an insulation sheet.

In addition, the resin portion 20 may be formed of electromagnetic wave absorbent resin having electromagnetic wave absorbence. For example, the resin portion 20 may be formed of resin having electromagnetic wave absorbence by mixing an electromagnetic wave absorbent material such as a carbon micro-coil. The electromagnetic wave absorbence refers to a property of absorbing electromagnetic waves, that is, attenuating electromagnetic energy. The electromagnetic wave absorbence is different from electromagnetic shield that blocks electromagnetic waves (that is, transmission is prevented by reflecting the electromagnetic energy). The resin portion 20 may be formed of various types of existing electromagnetic wave absorbent resin such as electromagnetic wave absorbent resin based on an electric conductor, electromagnetic wave absorbent resin based on a magnetic loss, and electromagnetic wave absorbent resin based on a dielectric loss. Since the resin portion 20 has the electromagnetic wave absorbence, it is possible to reduce influence of electromagnetic waves between the electronic components mounted on the mount board 10. Note that the electromagnetic wave absorbent resin has conductivity in many cases. In order to prevent electrical connection between the conductor exposure portions 13, the sheet 30 is formed of an insulation sheet.

The sheet 30 is a sheet arranged on the mount surface of the mount board 10. The sheet 30 is formed of paper, fabric, or resin. The sheet 30 has one surface adjoining the mount board 10 and the other surface adjoining the resin portion 20. The sheet 30 has substantially the same size as that of the surface of the mount board 10. The sheet 30 is placed on the mount board 10 so as to make contact with the entire mount surface. As described above, the resin portion 20 is formed by injecting molten resin onto the sheet 30 and solidifying it, so that it is fixed on the sheet 30. For this reason, the sheet 30 is bonded to the surface of the resin portion 20 with a peel-offresistance.

The surface of the sheet 30 does not have adhesiveness. Here, the "adhesiveness" refers to a property of bonding a pair of bonding target objects by chemical and/or physical forces. Note that the "adhesiveness" in a narrow sense (hereinafter, referred to as "strong adhesiveness") refers to a property of bonding a pair of bonding target objects with a peel-off resistance as a liquid adhesive is solidified. The adhesiveness also includes "stickiness" by which an object is bonded to a target surface even without a solvent or heat, and the object can be easily removed from the bonding surface. The sheet 30 may not have the adhesiveness on both surfaces or may not have adhesiveness on only one surface (that is, may have adhesiveness on only one surface). If the sheet 30 has only one surface having no adhesiveness, the mount surface side is used as the non-adhesive surface.

Any sheet has a certain degree of rigidity (stiffness). For this reason, even when a pressure is applied from the resin portion 20 on the sheet 30, the entire surface of the sheet 30 does not perfectly abut on the mount surface of the mount board 10. For example, a cavity A surrounded by the sheet 30 and the mount surface is formed in a step portion between the electronic component 12 and the printed circuit board 11 as illustrated in FIG 1. As described above, in many circuit boards, the lateral-projecting type semiconductor package is mounted. Similarly, in this embodiment, a QFP type semiconductor package (electronic component 12 of FIG 1) in which terminals 12a are projected from four lateral sides is mounted on the mount board 10. For this reason, the cavity A is formed at least in the vicinity of the terminal 12a (that is, in the vicinity of the conductor exposure portion 13). Note that the cavity A is not limited to the space formed in a step portion between the lateral-projecting type semiconductor package and the printed circuit board 11. A space formed in a step portion between an electronic component other than the lateral-projecting type semiconductor package (for example, a capacitor, a resistor, other semiconductor packages, and the like) and the printed circuit board 11 may also be considered as the cavity A.

The heat path 40 is a heat-radiating component capable of radiating heat of the electronic component 12 to the outside or a heat transfer component capable of transferring the heat of the electronic component 12 to other components. The heat path 40 may be a metal body directly or indirectly connected to the heat sink such as a heat dissipation fin. In addition, the heat path 40 may be a heat sink itself Furthermore, the heat path 40 may also be a casing of the circuit board device 1. A casing of a consumer product where the circuit board device 1 is mounted may also be considered as the heat path 40.

The heat path 40 includes a heat path 41 and a heat path 42. Both the heat paths 41 and 42 have a plate shape and are arranged in parallel with each other by interposing the mount board 10. More specifically, the heat path 41 is arranged in parallel with the mount board 10 to a position facing the mount surface of the mount board 10. The heat path 42 is arranged in parallel with the mount board 10 to face the non-mount surface of the mount board 10.

Note that the heat paths 41 and 42 may be integrated into a single body or may be separate bodies. According to this embodiment, the heat path 40 is a rectangular parallelepiped casing. Each of the heat paths 41 and 42 is one surface of the casing thereof The heat path 40 is formed of metal having a high thermal conductivity such as aluminum or iron. The heat path 40 also serves as an electromagnetic shield capable of blocking external electromagnetic waves from intruding into the inside of the circuit board device 1.

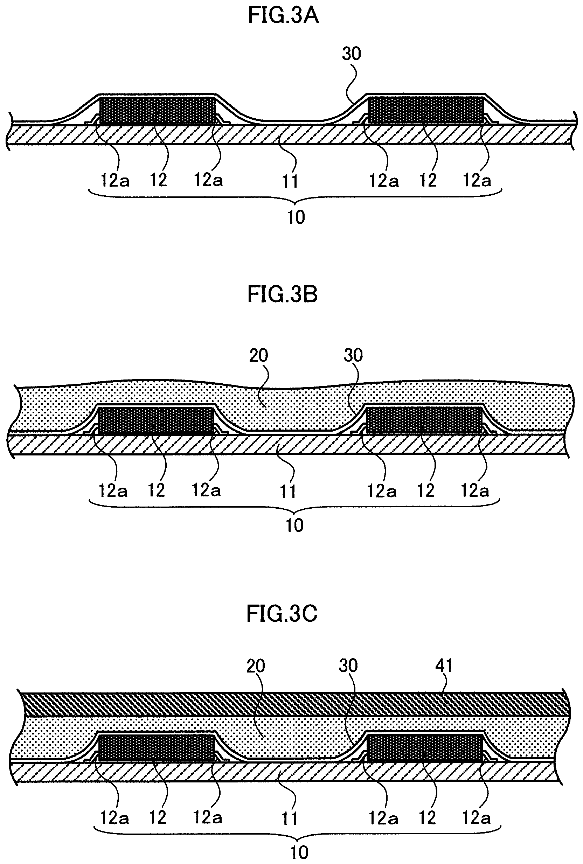

Next, a method of manufacturing the circuit board device 1 will be described. FIGS. 3A to 3C are diagrams illustrating a manufacturing process of the circuit board device 1. The circuit board device 1 may be assembled manually with human hands or may also be assembled automatically using a mechanical machine such as a manufacturing robot. In the following description, it is assumed that the circuit board device 1 is assembled manually with human hands (hereinafter, referred to as a device manufacturer).

First, as illustrated in FIG 3A, the device manufacturer places a single flat sheet 30 on the mount surface of the mount board 10. As described above, the sheet 30 has substantially the same size as that of the surface of the mount board 10. The device manufacturer places the sheet 30 on the mount surface to cover the entire mount surface.

Then, the device manufacturer injects resin portion 20 molten by heat onto the sheet 30 as illustrated in FIG 3B. In this case, the device manufacturer may inject the resin portion 20 dividingly over several times while performing vacuum evacuation in order to prevent a void from remaining in the resin portion 20.

Subsequently, the device manufacturer places the heat path 41 on the resin portion 20 before solidification of the resin portion 20 as illustrated in FIG 3C. If the heat paths 41 and 42 are separate bodies, the device manufacturer places the heat path 42 on the non-mount surface of the mount board 10 as illustrated in FIG 1. As a result, the circuit board device 1 is completed.

Alternatively, the heat path 41 may also be arranged before injecting the resin portion 20 onto the sheet 30. In this case, the device manufacturer may form the resin portion 20 by arranging the heat path 41 in a position far from the mount board 10 by a certain distance and then injecting the molten resin 20 into a gap between the sheet 30 and the heat path 41.

According to this embodiment, since the sheet 30 is arranged between the resin portion 20 and the mount board 10, the cavity A is formed between the resin portion 20 and the mount board 10. Even when the resin portion 20 is inflated by the heat generated from the electronic component 12, the pressure is alleviated by the cavity A. Therefore, a significant problem does not occur in the mount board 10.

In particular, if the electronic component 12 is a lateral-projecting type semiconductor package such as the SOP or QFP type package, the cavity A is formed in the vicinity of the terminal 12a. For this reason, even when the resin portion 20 is inflated, a significant load is not applied to the terminal 12a. Therefore, the terminal 12a of the semiconductor package is not easily separated from the printed circuit board 11.

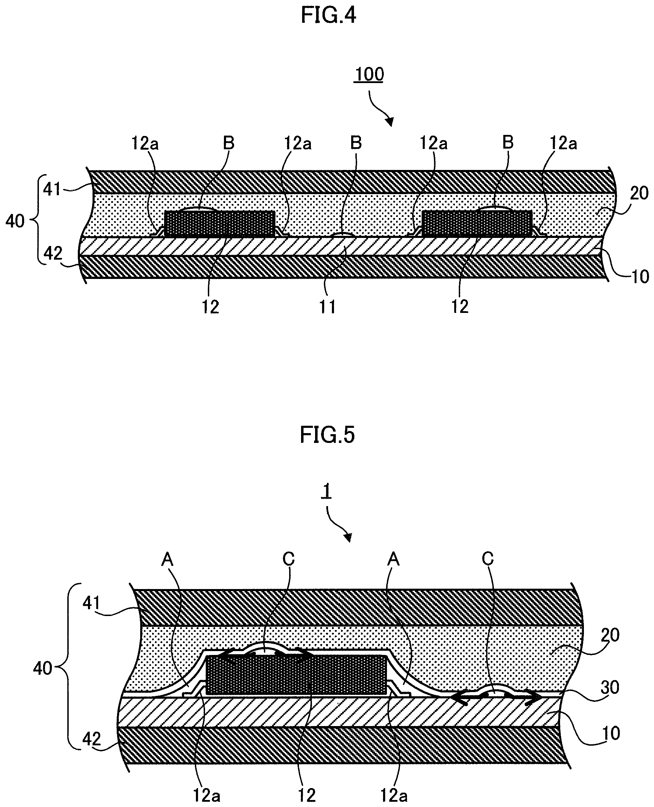

Note that, in a case where the sheet 30 is not arranged between the resin portion 20 and the mount board 10, a void (dead air space) may be generated between the resin portion 20 and the mount surface of the mount board 10 during solidification of the resin portion 20. FIG 4 illustrates a circuit board device 100 in which no sheet 30 is arranged between the resin portion 20 and the mount board 10. In FIG 4, the reference symbol "B" denotes the void formed between the mount surface and the resin portion 20. The resin portion 20 is shrunken during the solidification. For this reason, even when the resin portion 20 is injected into the gap between the mount board 10 and the heat path 41 while performing vacuum evacuation, it is difficult to perfectly remove the void B from the mount board 10.

In a case where no sheet 30 is provided between the resin portion 20 and the mount board 10, the resin portion 20 is bonded to the surface of the mount board 10. For this reason, a void B is perfectly encapsulated on the electronic component 12 or the printed circuit board 11. If the resin portion 20 is inflated in this state, a significant pressure is applied to the void B, but the air inside the void B has no place to evacuate. As a result, an uneven pressure is applied to the mount board 10. Depending on how pressure is applied, there is a possibility that a significant problem may occur in the mount board 10. For example, in a case where a void B is formed on the electronic component 12, and the resin portion 20 is inflated, the pressure applied to the electronic component 12 is biased to one side of the upper surface of the electronic component 12. In addition, there is a possibility that the terminal 12a may be removed from the printed circuit board 11. Furthermore, in a case where the void B is formed on the printed circuit board 11, the printed circuit board 11 may be deformed, so that a pattern may be disconnected.

However, in the circuit board device 1 according to this embodiment, the sheet 30 is provided between the resin portion 20 and the mount board 10. Since the surface of the resin portion 20 and the sheet 30 are bonded to each other as described above, the sheet 30 is deformed to match the shape of the surface of the resin portion 20 as illustrated in FIG 5 even when the resin portion 20 is shrunken. Since the sheet 30 remains to stick to the surface of the resin portion 20, a void is not easily formed between the sheet 30 and the resin portion 20. In addition, at least the mount surface side of the sheet 30 has nearly no adhesiveness. For this reason, for example, even when a void C is formed between the sheet 30 and the mount board 10, the air inside the void C spreads along the surface of the sheet 30 in the event of inflation of the resin portion 20 as indicated by the arrow of FIG 5. Therefore, since the uneven pressure is less likely to be applied to the mount board 10, a possibility of a problem occurring in the mount board 10 is reduced.

Note that, in a case where the sheet 30 is not provided between the mount board 10 and the resin portion 20, the resin portion 20 is bonded to the surface of the mount board 10. For this reason, it is very difficult to check a state of the mount board 10 by removing the mount board 10 from the circuit board device 100 after completely manufacturing the circuit board device 100. However, in the circuit board device 1 according to this embodiment, at least the mount surface side of the sheet 30 has no adhesiveness. For this reason, a user can easily disassemble the mount board 10 from the circuit board device 1 even after the manufacturing of the circuit board device 1. Therefore, it is possible to implement excellent maintainability of the circuit board device 1. In particular, a component generating a large amount of heat tends to have a short operating life, and also tends to have high frequency of part replacement. If the circuit board device has the component generating the large amount of heat, it is possible to facilitate part replacement. Using the circuit board device 1 according to this embodiment, the mount board 10 can be easily disassembled. Therefore, part replacement becomes easy.

In some cases, heat is concentrated on a particular part on the mount board. In such a case of the circuit board device, only a part of the resin portion is significantly inflated by the heat, and the mount board is likely to be deformed. Therefore, it is difficult to place the resin portion between the mount board and the heat path. However, in the circuit board device 1 according to this embodiment, even when the resin portion 20 is inflated, a pressure thereof is alleviated. For this reason, it is possible to arrange the resin portion 20 between the mount board 10 and the heat path 41. Since the heat is dispersed by the resin portion 20 and is transferred to the heat path 41, it is possible to obtain a high heat radiation property in the circuit board device 1 even when the heat path 41 is thin. As a result, it is possible to reduce a dimension of the circuit board device 1 in a height direction (thickness direction).

### Second Embodiment

The mount board 10 provided in the circuit board device 1 of the first embodiment is the single-sided mount board. Alternatively, the mount board 10 may be a double-sided mount board. A circuit board device 2 provided with a double-sided mount board 10 will now be described.

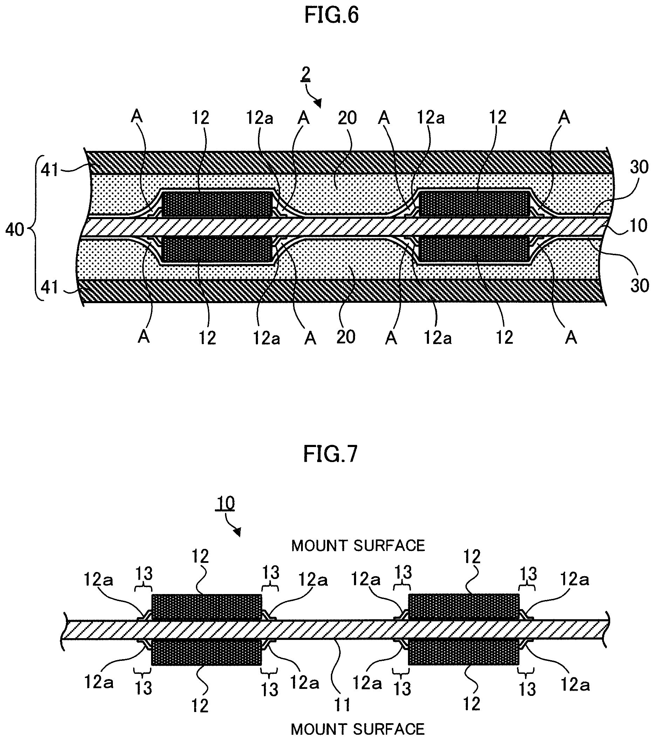

FIG 6 is a diagram illustrating a circuit board device 2 according to the second embodiment. The circuit board device 2 has a mount board 10, a resin portion 20, a sheet 30, and a heat path 40. The heat path 40 includes a pair of heat paths 41 arranged in upper and lower sides by interposing the mount board 10.

The mount board 10 is the double-sided mount board in which electronic components are mounted on both sides. FIG 7 illustrates only the mount board 10 removed from the circuit board device 2. The mount board 10 has a printed circuit board 11 and electronic components 12 mounted on both sides of the printed circuit board 11. The electronic components 12 are arranged on the same positions on both sides of the printed circuit board 11, and the mount board 10 is vertically symmetrical. Note that this embodiment is merely for illustrative purposes. The electronic components 12 may not be arranged in the same position on both sides of the printed circuit board 11.

Returning to FIG 6, the resin portion 20 is formed of resin for transferring heat of the electronic component 12 to the heat path 41. The resin portions 20 are arranged on both sides of the mount board 10.

The sheet 30 is arranged on the mount surface of the mount board 10. According to the second embodiment, both sides of the mount board 10 serve as the mount surface. For this reason, the sheets 30 are provided on both sides of the mount board 10. Similar to the first embodiment, a cavity A surrounded by the sheet 30 and the mount surface is formed in a step portion of the electronic component 12 (in the vicinity of the terminal 12a).

Other configurations of the mount board 10, the resin portion 20, the sheet 30, and the heat path 40 are similar to those of the first embodiment.

According to this embodiment, the heat paths 41, the sheets 30, and the resin portions 20 are arranged on both sides of the mount board 10. Therefore, even when the resin portion 20 is inflated, the pressures are applied from both sides of the mount board 10. For this reason, compared to a case where the resin portion 20 is provided on only one side, deformation of the mount board 10 is reduced. Therefore, a possibility of a significant problem occurring in the mount board 10 is reduced.

### Third Embodiment

The circuit board device 1 of the first embodiment has a single flat sheet 30. However, the sheet 30 is not limited to a flat sheet. For example, the sheet 30 may have a concave portion. A circuit board device 3 having a sheet 30 provided with a concave portion will now be described.

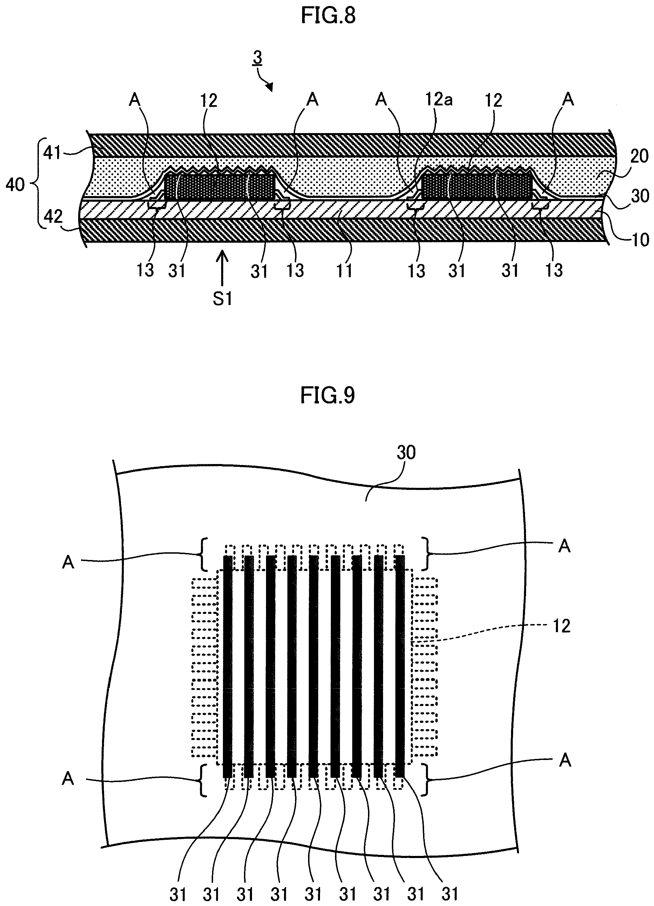

FIG 8 is a diagram illustrating a circuit board device 3 according to a third embodiment. The circuit board device 3 has a mount board 10, a resin portion 20, a sheet 30, and a heat path 40. Similar to the first embodiment, the heat path 40 includes a heat path 41 and a heat path 42. Similar to the first embodiment, the mount board 10 is a single-sided mount board.

The sheet 30 is arranged on a mount surface of the mount board 10. The sheet 30 is provided with a concave portion recessed as seen from the mount board 10 side. The concave portion 31 is formed, for example, by corrugating the sheet 30.

FIG 9 is a diagram illustrating the sheet 30 as seen from the mount board 10 side (from S1 in FIG 8). That is, FIG 9 illustrates a mount surface side face of the sheet 30. In FIG 9, the dotted line indicates a position of the electronic component 12. The concave portion 31 is illustrated as a plurality of lines (in the example of FIG 9, straight lines) formed on the mount surface side face of the sheet 30 at equal intervals. More specifically, the concave portion 31 is formed in a stripe shape in a position corresponding to the upper surface of the electronic component 12. At least a part of the lines of the concave portion 31 are positioned in the vicinity of the cavity A. Note that the cavity A is not limited to a space formed in a step portion between the lateral-projecting type semiconductor package and the printed circuit board 11. A space formed in a step portion between an electronic component other than the lateral-projecting type semiconductor and the printed circuit board 11 may also be considered as the cavity A.

Note that, although the concave portion 31 is formed only on a part of the upper surface of the electronic component 12 in FIGS. 8 and 9, the concave portion 31 may also be formed in a part of the printed circuit board 11. In addition, the concave portion 31 may also be formed on the entire surface of the sheet 30.

Other configurations of the circuit board device 3 are similar to those of the circuit board device 1 of the first embodiment.

Note that the circuit board device 3 may also be obtained by modifying the sheet 30 of the circuit board device 2 of the second embodiment. Specifically, the circuit board device 3 may include a mount board 10 having both sides where electronic components 12 are mounted, and heat paths 41, sheets 30, and resin portions 20 arranged in both sides of the mount board 10. In this case, the concave portions 31 may be provided in both upper and lower sheets 30.

According to this embodiment, the concave portion 31 is provided on the sheet 30. Therefore, even when the resin portion 20 is inflated, the space formed in the concave portion 31 alleviates the pressure. Therefore, a significant problem does not occur in the mount board 10.

In addition, the concave portion 31 has a line shape, and a part of the lines are positioned in the cavity A. Even when a pressure is applied to the concave portion 31, the air inside the concave portion 31 can be easily evacuated to the cavity A, so that the air pressure inside the concave portion 31 does not easily increase. Therefore, a possibility that the concave portion 31 itself causes a problem is low.

Note that, in a case where the concave portion 31 is not provided on the sheet 30, a void C maybe generated between the sheet 30 and the mount surface as illustrated in FIG 5. As described in the first embodiment, the mount surface side of the sheet 30 has no adhesiveness. For this reason, even when a pressure is applied to the void C due to inflation of the resin portion 20, the air inside the void C is dispersed along the surface of the sheet 30. However, even in this case, it is certain that the sheet 30 is strongly pressed toward the mount surface by virtue of the pressure of the resin portion 20. Therefore, some resistance exists in the dispersion of the air. In this regard, the concave portion 31 is provided on the sheet 30 of the circuit board device 3 according to the third embodiment. For this reason, for example, even when a void is generated between the sheet 30 and the mount surface, the air inside the void is evacuated to the cavity A through the concave portion 31 without resistance. Therefore, since an uneven pressure is not easily generated by the void, a possibility that a problem occurs in the mount board 10 is further reduced.

### Fourth Embodiment

A gap formed between the mount board 10 and the resin portion 20 may generate a waveguide effect and serve as a passage of electromagnetic waves in some cases. In this case, an electromagnetic wave generated from one electronic component 12 is transmitted to the other electronic component 12 through the gap. A stronger electromagnetic wave is transmitted to the other electronic component 12, compared to a case where the resin portion 20 is not provided between the mount board 10 and the heat path 41. In this regard, transmission of electromagnetic waves is suppressed by forming the sheet 30 from an electromagnetic wave absorption sheet. A circuit board device 4 provided with the sheet 30 as an electromagnetic wave absorption sheet will now be described.

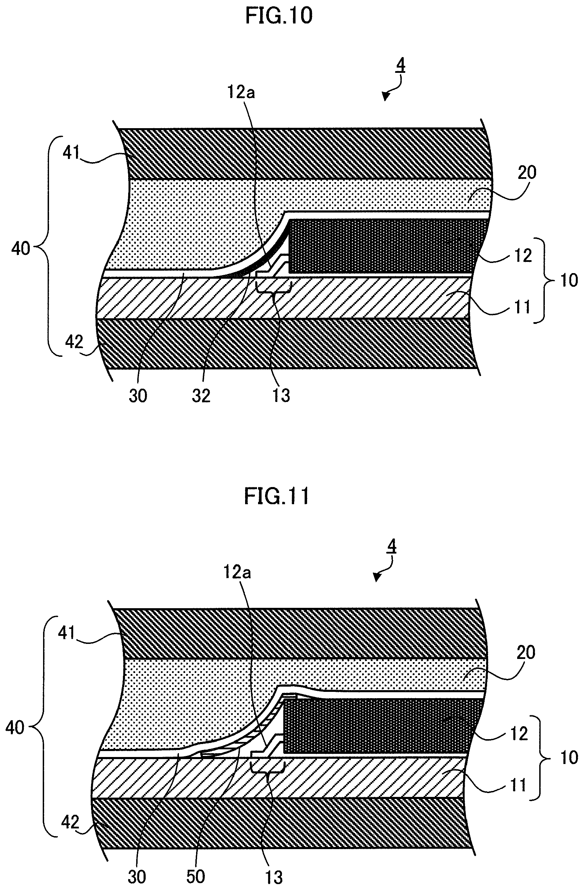

FIG 10 is a diagram illustrating the circuit board device 4 according to the fourth embodiment. The circuit board device 4 has a mount board 10, a resin portion 20, a sheet 30, and a heat path 40. The heat path 40 includes a heat path 41 and a heat path 42. The mount board 10 is a single-sided mount board.

The sheet 30 is arranged on the mount surface of the mount board 10. The sheet 30 is the electromagnetic wave absorption sheet. The sheet 30 is formed of, for example, conductive fiber fabrics. Note that the sheet 30 may be any one of various existing electromagnetic wave absorption sheets without limiting to the conductive fiber fabrics.

The electromagnetic wave absorption sheet has electric conductivity in many cases. In order to prevent the conductor exposure portions 13 from being electrically connected to each other through the sheet 30, an insulation film 32 is formed in a part of the surface of the sheet 30 facing the conductor exposure portion 13.

Other configurations of the circuit board device 4 are similar to those of the circuit board device 1 of the first embodiment.

Note that the circuit board device 4 may also be obtained by modifying the sheet 30 of the circuit board device 2 of the second embodiment. That is, the circuit board device 4 may include a mount board 10 having both sides where electronic components 12 are mounted, and a heat path 41, a sheet 30, and the resin portion 20 arranged on both sides of the mount board 10. In this case, insulation films 32 are provided on both upper and lower sheets 30.

In addition, the circuit board device 4 may also be obtained by modifying the sheet 30 of the circuit board device 3 of the third embodiment. That is, the sheet 30 of the circuit board device 4 may have a concave portion 31. Similarly, in this case, the sheet 30 is provided with the insulation film 32.

According to this embodiment, the sheet 30 is the electromagnetic wave absorption sheet. Therefore, it is possible to reduce influence of electromagnetic waves between electronic components mounted on the mount board 10. In addition, since the insulation film 32 is formed in a part of the surface of the sheet 30 facing the conductor exposure portion 13, a problem that may be generated when the conductor exposure portions 13 are electrically connected through the sheet 30 is also reduced.

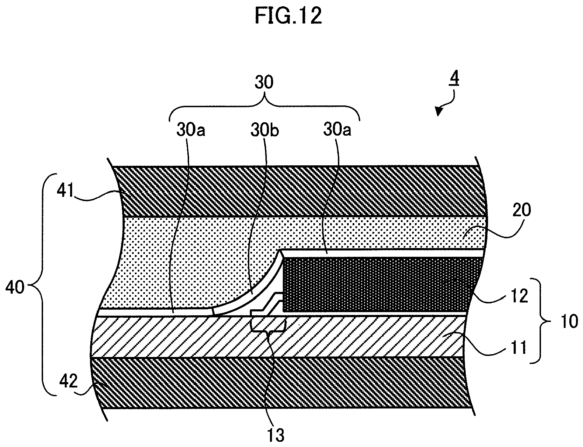

A means for preventing electric connection between the conductor exposure portions 13 is not limited to the insulation film 32. For example, an insulation material 50 may be arranged in a part of the surface of the sheet 30 facing the conductor exposure portion 13. FIG 11 illustrates an example in which an insulation sheet as the insulation material 50 is arranged in the part facing the conductor exposure portion 13. In addition, the insulation sheet may also be provided in a part of the sheet 30 facing the conductor exposure portion 13. FIG 12 illustrates an example in which the insulation sheet 30b is formed in the part of the sheet 30 facing the conductor exposure portion 13. In this example, parts other than the part facing the conductor exposure portion 13 serve as the electromagnetic wave absorption sheet 30a. The sheet 30 is formed, for example, by joining and bonding the electromagnetic wave absorption sheet 30a and the insulation sheet 30b.

### Fifth Embodiment

The circuit board devices of the first to fourth embodiments have the sheet 30 between the mount board 10 and the resin portion 20. However, the sheet 30 may not be provided between the mount board 10 and the resin portion 20. A circuit board device 5 having no sheet 30 between the mount board 10 and the resin portion 20 will now be described.

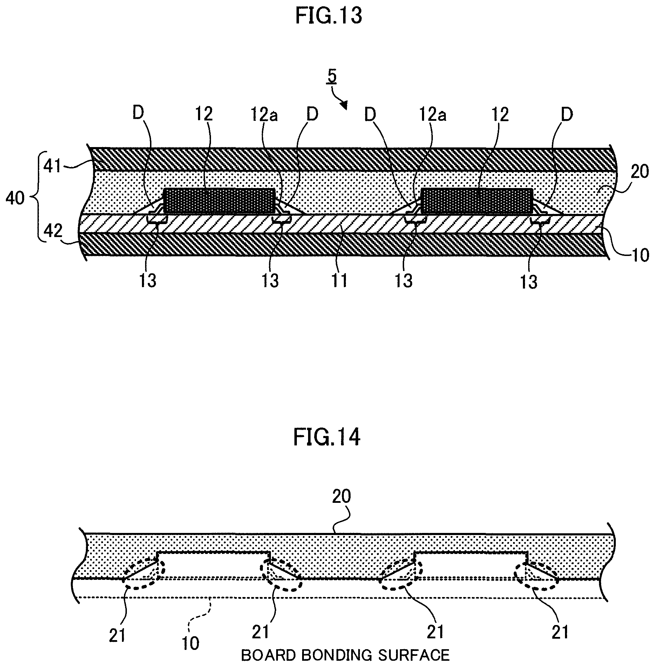

FIG 13 is a diagram illustrating a circuit board device 5 according to a fifth embodiment. The circuit board device 5 includes a mount board 10, a resin portion 20, and a heat path 40. Similar to the first embodiment, the heat path 40 includes a heat path 41 and a heat path 42. Similar to the first embodiment, the mount board 10 is the single-sided mount board.

The resin portion 20 is formed of resin for transferring heat of the electronic component 12 to the heat path 41. FIG 14 illustrates only the resin portion 20 removed from the circuit board device 5. A surface of the resin portion 20 facing the heat path 41 is flattened to match the shape of the heat path 41. A surface of the resin portion 20 facing the mount board 10 (hereinafter, referred to as a board-bonding surface) has a shape that can be bonded to the mount surface of the mount board 10. The board-bonding surface is a non-adhesive surface.

Note that a non-bonding portion 21 for separating the resin portion 20 and the mount surface is provided on the board-bonding surface of the resin portion 20. The non-bonding portion 21 is a part of the resin portion 20 chamfered inward of the resin portion 20 from an expected contact surface in order to separate the resin portion 20 from the mount surface of the mount board 10 by a certain distance. Here, the expected contact surface refers to a surface of the resin portion 20 expected to make contact with the mount surface when the resin portion 20 is bonded to the mount surface (that is, a surface where the mount surface is placed when the resin portion 20 is bonded to the mount surface). The non-bonding portion 21 is formed in a part of the mount surface facing the conductor exposure portion 13. By providing the non-bonding portion 21 on the board-bonding surface, a cavity D surrounded by the resin portion 20 and the mount surface is formed on the conductor exposure portion 13 of the mount board 10 as illustrated in FIG 13.

The resin portion 20 is manufactured, for example, using a three-dimensional (3D) printer. Specifically, the resin portion 20 is manufactured in the following sequence. First, a device manufacturer performs 3D-scanning for the mount surface of the mount board 10 using a 3D-scanner. In addition, the device manufacturer processes the scan data with a computer to create 3D data of the resin portion 20. Then, the device manufacturer inputs the 3D data to the 3D printer and operates the 3D printer to manufacture the resin portion 20.

Other configurations of the circuit board device 5 are similar to those of the circuit board device 1 of the first embodiment.

According to this embodiment, a cavity D is formed between the resin portion 20 and the mount board 10 by arranging the non-bonding portion 21 on the board-bonding surface of the resin portion 20. Even when the resin portion 20 is inflated by the heat generated from the electronic component 12, the pressure is alleviated by the cavity D. Therefore, a significant problem does not occur in the mount board 10.

In addition, since the board-bonding surface is the non-adhesive surface, a user can easily remove the mount board 10 from the circuit board device 5 even after the manufacturing of the circuit board device 5. Therefore, it is possible to provide excellent maintainability of the circuit board device 1.

### Sixth Embodiment

The sheet 30 of the circuit board device 1 of the first embodiment is the single flat sheet. However, the sheet 30 is not limited to the flat sheet. For example, the sheet 30 may have a domical protrusion. A circuit board device 6 according to the sixth embodiment will now be described.

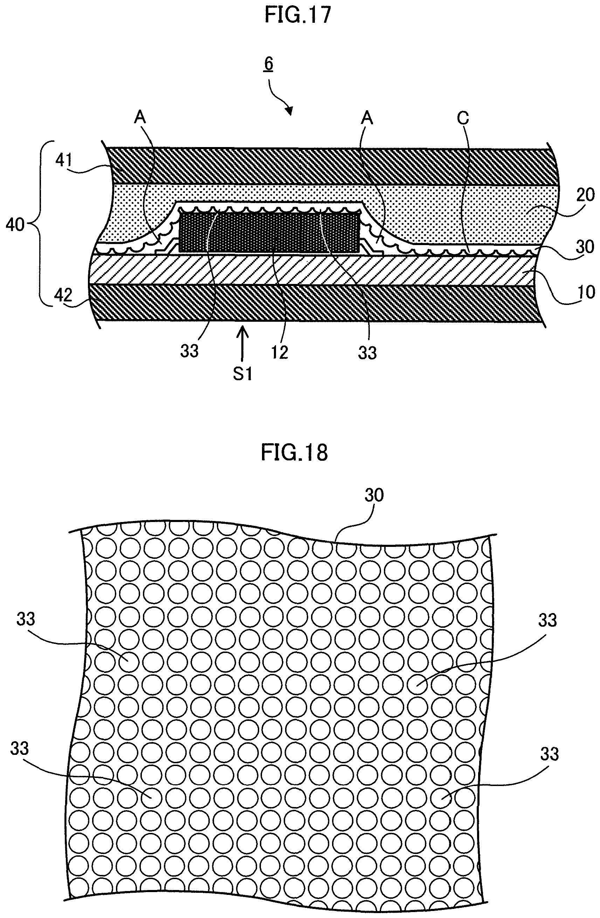

FIG 17 is a diagram illustrating the circuit board device 6 according to the sixth embodiment. The circuit board device 6 has a mount board 10, a resin portion 20, a sheet 30, and a heat path 40. Similar to the first embodiment, the heat path 40 includes a heat path 41 and a heat path 42. Similar to the first embodiment, the mount board 10 is the single-sided mount board.

The sheet 30 is arranged on a mount surface of the mount board 10. The sheet 30 is provided with a plurality of domical protrusions 33 protruding toward the mount board 10. The protrusions 33 are formed of a soft material such as rubber or sponge. If a base portion of the sheet 30 (flat portion other than the protrusions 33) is formed of paper, fabric, or resin, the protrusions 33 may be formed of the same material as that of the base portion of the sheet 30. In order to improve a heat transfer property, it is desirable that there is no cavity inside the protrusion 33.

FIG 18 is a diagram illustrating the sheet 30 as seen from the mount board 10 side (from the arrow direction S1 in FIG 17). That is, FIG 18 illustrates a mount surface side face of the sheet 30. The protrusions 33 are formed across the entire surface of the sheet 30. The protrusion 33 has, for example, a circular shape as seen from the mount board 10 side. The protrusion 33 has, for example, a diameter of 1 to 3 mm. Naturally, the size of the protrusion 33 is not limited thereto. Note that the shape of the protrusion 33 is not limited to the circular shape. The protrusion 33 may have a polygonal shape (such as rectangular, hexagonal, or octagonal shapes) as seen from the mount board 10 side. Note that, although the protrusions 33 are formed across the entire surface of the sheet 30 in FIGS. 17 and 18, the protrusions 33 may be formed only on a portion facing the upper surface of the electronic component 12.

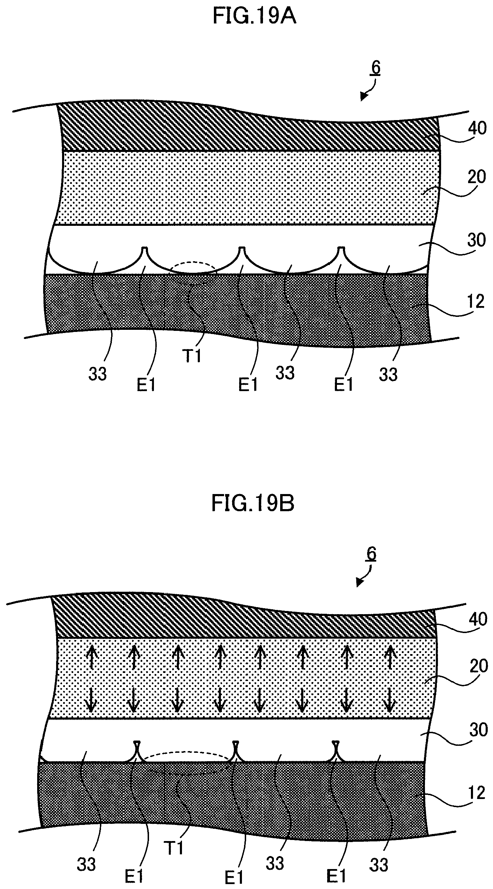

FIG 19A is an enlarged view illustrating the vicinity of the sheet 30 while the electronic component 12 is not heated. As described above, the protrusion 33 has a domical shape protruding toward the mount board 10. That is, the apex portion T1 of the protrusion 33 has a curved face protruding toward the mount board 10. If the apex portion T1 of the protrusion 33 is flat, a void may be generated between the apex portion T and the electronic component 12 as illustrated in FIG 5. The void may apply an excessive pressure to the electronic component 12. However, since the apex portion T1 of the protrusion 33 has the curved face, there is no worry about the void generated between the apex portion T1 and the electronic component 12.

FIG 19B is an enlarged view illustrating the vicinity of the sheet 30 while the electronic component 12 is heated. The resin portion 20 is inflated by the heat of the electronic component 12. Then, the pressure from the resin portion 20 presses the protrusion 33, so that the pressure transmitted from the resin portion 20 to the electronic component 12 is alleviated. In addition, as the protrusion 33 is pressed, a cavity E1 provided between the protrusions 33 and 33 is reduced. In addition, a contact area between the apex portion T1 of the protrusion 33 and the electronic component 12 increases. As a result, heat transfer performance from the electronic component 12 to the sheet 30 is improved.

Other configurations of the circuit board device 6 are similar to those of the circuit board device 1 of the first embodiment. Note that the circuit board device 6 may also be obtained by modifying the sheet 30 of the circuit board device 2 of the second embodiment. That is, the circuit board device 6 may include a mount board 10 having both sides where the electronic components 12 are mounted, and a heat path 41, a sheet 30, and a resin portion 20 arranged in both sides of the mount board 10. In this case, the protrusions 33 may be provided on both upper and lower sheets 30.

According to this embodiment, the protrusions 33 are provided on the sheet 30. For this reason, even when the resin portion 20 is inflated by the heat of the electronic component 12, the protrusion 33 spreads to the space E1 to alleviate the pressure transmitted from the resin portion 20 to the electronic component 12. Therefore, a significant problem does not occur in the mount board 10. Even when the circuit board device 6 has the space E1 (air layer) that increases a heat transfer resistance, the protrusion 33 is pressed, and the space E1 is reduced as the electronic component 12 is heated. Therefore, the circuit board device 6 can maintain an excellent heat transfer property.

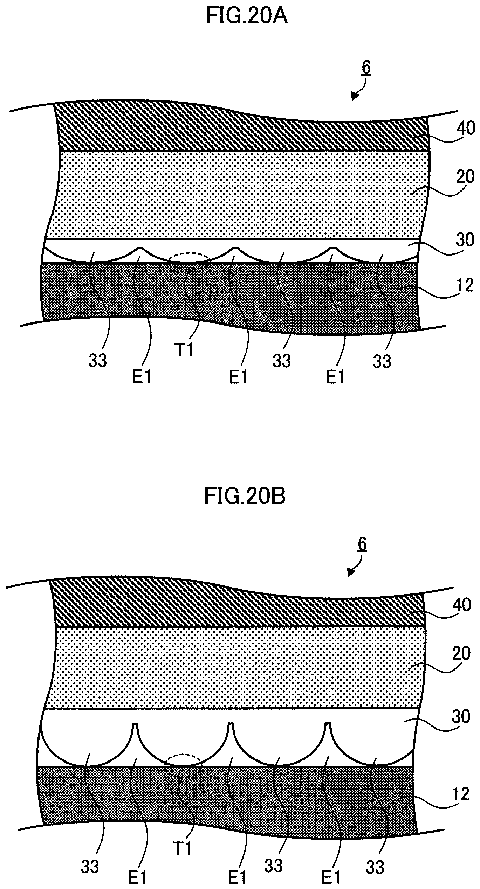

Note that a curvature of the protrusion 33 as seen from a horizontal direction of the sheet 30 is not limited to those illustrated in FIGS. 17 to 19B. For example, the curvature of the protrusion 33 may be small as illustrated in FIG 20A. That is, the protrusions 33 may be shallower than those of FIGS. 17 to 19B. In addition, the curvature of the protrusion 33 may be larger as illustrated in FIG 20B. That is, the protrusions 33 may be deeper than those of FIGS. 17 to 19B.

### Seventh Embodiment

In the circuit board device 5 according to the fifth embodiment, the surface of resin portion 20 of the mount board 10 side is flat. However, similar to the sheet 30 of the fifth embodiment, a domical protrusion may also be formed on the surface of the resin portion 20 of the mount board 10 side. A circuit board device 7 according to the seventh embodiment will now be described.

Similar to the circuit board device 5 according to the fifth embodiment, the circuit board device 7 includes a mount board 10, a resin portion 20, and a heat path 40. Similar to the first embodiment, the heat path 40 includes a heat path 41 and a heat path 42. Similar to the first embodiment, the mount board 10 is the single-sided mount board.

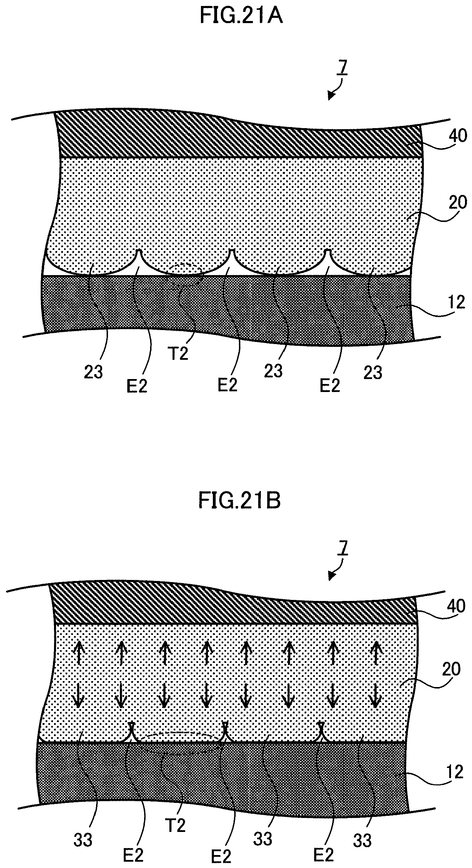

FIG 21A is an enlarged view illustrating the vicinity of the resin portion 20 while the electronic component 12 is not heated. The resin portion 20 is provided with a plurality of domical protrusions 23 protruding toward the mount board 10. That is, the apex portion T2 of the protrusion 23 has a curved face protruding toward the mount board 10. The protrusion 23 is formed of a soft material such as rubber or sponge. The protrusion 23 may also be formed of the same material as that of the substrate of the resin portion 20. In order to improve a heat transfer property, it is desirable that there is no cavity inside the protrusion 23. Similar to the protrusions 33 of FIGS. 20A and 20B, the protrusion 23 may be formed to be shallower or deeper. In addition, the size and the shape of the protrusion 23 may be similar to those of the protrusion 33 of the sixth embodiment.

FIG 21B is an enlarged view illustrating the vicinity of the resin portion 20 while the electronic component 12 is heated. As the resin portion 20 is inflated by the heat of the electronic component 12, the protrusion 23 is pressed. In addition, the pressure transmitted from the resin portion 20 to the electronic component 12 is alleviated. Furthermore, as the protrusion 23 is pressed, the cavity E2 provided between the protrusions 23 and 23 is reduced. At the same time, a contact area between the apex portion T2 of the protrusion 23 and the electronic component 12 increases. As a result, heat transfer performance from the electronic component 12 to the resin portion 20 is improved.

According to this embodiment, the protrusions 23 are provided on the resin portion 20. For this reason, even when the resin portion 20 is inflated by the heat of the electronic component 12, the protrusion 23 spreads to the space E2 and is pressed to alleviate the pressure transmitted from the resin portion 20 to the electronic component 12. Therefore, a significant problem does not occur in the mount board 10. Even when the circuit board device 7 has the space E2 (air layer) that increases a heat transfer resistance, the protrusion 23 is pressed, and the space E2 is reduced as the electronic component 12 is heated. Therefore, the circuit board device 7 can maintain an excellent heat transfer property.

Each of the embodiments described above are mere for illustrative purposes, and various modifications and applications may also be possible.

For example, although the SOP type or QFP type semiconductor package is employed as the lateral-projecting type semiconductor package in the embodiments described above, the lateral-projecting type semiconductor package is not limited to the SOP and QFP types. The lateral-projecting type semiconductor package may include, for example, a dual inline package (DIP) type semiconductor package, a small outline J-leaded (SOJ) type semiconductor package, a plastic leaded chip carrier (PLCC) type semiconductor package, and the like.

Although the mount surface side face of the sheet 30 is the non-adhesive surface in the first to fourth embodiments, the mount surface side face of the sheet 30 may also have stickiness (adhesiveness with weak peel-off resistance).

Although the concave portion 31 is formed in a straight line shape in the third embodiment, the shape of the concave portion 31 is not limited to the straight line shape. For example, the concave portion 31 may be formed in a dotted line shape. In addition, although the concave portion 31 of the third embodiment is formed on the sheet 30 in a stripe shape, the shape of the concave portion 31 is not limited to the stripe shape. For example, the concave portion 31 may be formed on the sheet 30 in a mesh shape.

Although the board-bonding surface of the resin portion 20 is a non-adhesive surface in the fifth embodiment, the board-bonding surface of the resin portion 20 may have stickiness.

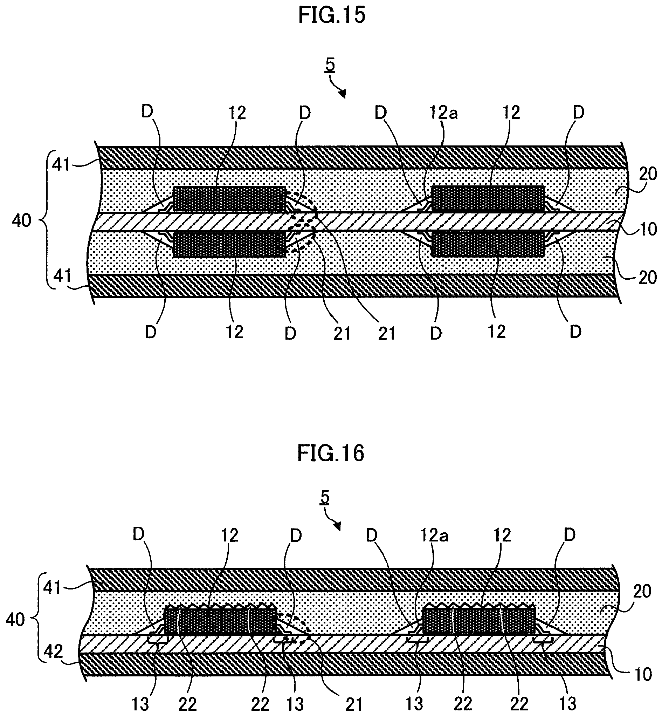

Furthermore, although the mount board 10 is a single-sided mount board in the circuit board device 5, the mount board 10 may be a double-sided mount board. In this case, in the circuit board device 5, the heat paths 41 and the resin portions 20 may be arranged on both sides of the mount board 10 as illustrated in FIG 15. In this case, the non-bonding portion 21 is provided in both the upper and lower resin portions 20. Even when the resin portion 20 is inflated, the pressure is applied from both sides of the mount board 10. Therefore, the mount board 10 is not easily significantly deformed. As a result, a possibility of a significant problem occurring in the mount board 10 is reduced.

As illustrated in FIG 16, the concave portion 22 may be provided on the board-bonding surface of the resin portion 20 of the circuit board device 5. The concave portion 22 has a line shape, and a part of the lines are positioned in the cavity D. Even when the resin portion 20 is inflated, the space formed in the concave portion 22 alleviates the pressure. Therefore, a significant problem in the mount board 10 does not occur. Furthermore, the concave portion 22 has the line shape, and the part of the lines are positioned in the cavity D. Even when a pressure is applied to the concave portion 22, the air inside the concave portion 22 can be easily evacuated to the cavity A. Therefore, a possibility that the concave portion 22 itself causes a problem is low. Furthermore, even when a void is generated between the resin portion 20 and the mount surface, the air inside the void is evacuated to the cavity A with nearly no resistance through the concave portion 22. Therefore, since an uneven pressure is not easily generated by the void, a possibility that a problem occurs in the mount board 10 is further lowered.

Note that, although the mount board 10 of FIG 16 is a single-side mount board, the mount board 10 may be a double-sided mount board. In this case, similar to the mount board of FIG 15, the heat paths 41 and the resin portions 20 may be arranged in both sides of the mount board 10 of the circuit board device 5 of FIG 16. The concave portions 22 may also be provided in both upper and lower resin portions 20.

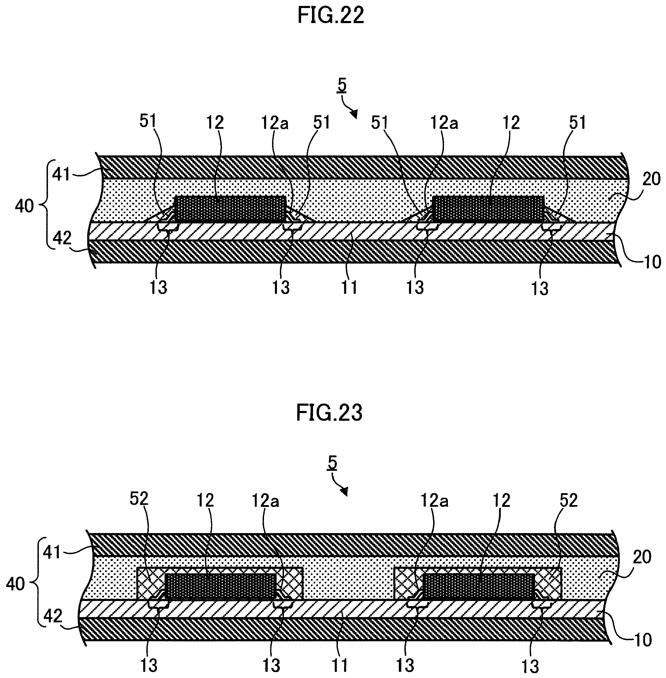

Although the space D is provided in the vicinity of the terminal of the electronic component 12 of the circuit board device 5 of the fifth embodiment, the space D in the vicinity of the terminal may be buried with insulation resin 51 as illustrated in FIG 22. In this case, the space D other than the vicinity of the terminal may not be buried with the insulation resin 51. In addition, the periphery of the electronic component 12 may be covered by insulation resin 52 as illustrated in FIG 23. Even when the resin portion 20 is formed of conductive resin, insulation between the terminals can be reliably obtained.

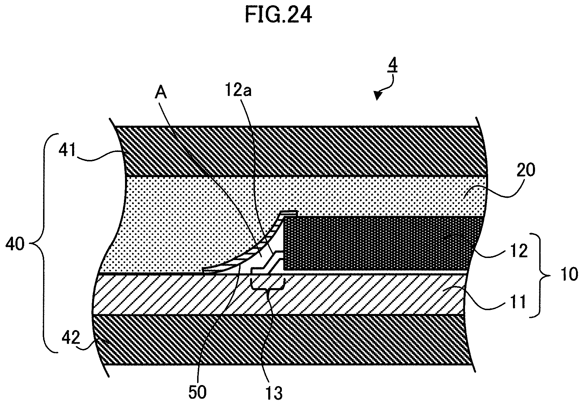

Although the sheet 30 covers the surface of the mount board 10 in the circuit board device 4 of the fourth embodiment, the sheet 30 may not be provided. As illustrated in FIG 24, the sheet provided on the surface of the mount board 10 may include only the insulation material 50 (insulation sheet) that covers the terminal portion of the electronic component 12. Since the sheet area is reduced, it is possible to lower the cost. Even in this configuration, a cavity A is provided in a portion surrounded by the insulation material 50 and the mount surface. Therefore, the pressure alleviation effect does not disappear.

The space (such as the cavity A and the space E1) between the sheet 30 and the mount board 10 described in the first to fourth and sixth embodiments may communicate with the outside. That is, a communication path (air path) that links the inner space and the outside may be provided in the circuit board devices 1 to 4 and 6. Since the air is evacuated to the outside through the communication path when the resin portion 20 is inflated, the pressure alleviation effect is further improved.

Similarly, the space (such as the cavity D and the space E2) between the resin portion 20 and the mount board 10 described in the fifth and seventh embodiments may communicate with the outside. That is, a communication path (air path) that links the inner space and the outside may be provided in the circuit board devices 5 and 7. Since the air is evacuated to the outside through the communication path when the resin portion 20 is inflated, the pressure alleviation effect is further improved.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions the accompanying claims and their equivalents are intended to cover such forms or modifications as would fall within the scope and spirit of the inventions.

## Claims

1. A circuit board device comprising:
a mount board (10) provided with an electronic component (12) and a printed circuit board (11) having at least one surface where the electronic component (12) is mounted;
a heat path (40) arranged to a position facing the mount surface of the mount board (10);
a sheet (30) arranged on the mount surface; and
a resin portion (20) arranged between the sheet (30) and the heat path (40),
wherein a cavity (D) surrounded by the sheet (30) and the mount surface is formed in a step portion between the electronic component (12) and the printed circuit board (11).

2. The circuit board device according to claim 1, wherein
the electronic component (12) mounted on the mount board (10) includes a lateral-projecting type semiconductor package having terminals projecting from lateral sides, and
the cavity (D) is formed in a portion of the terminal of the lateral-projecting type semiconductor package.

3. The circuit board device according to claim 1 or 2, wherein
the sheet (30) has a non-adhesive surface at least on the mount surface side.

4. The circuit board device according to any one of claim 1 to 3, wherein
the resin portion (20) is resin mixed with metal powder, and
the sheet (30) is an insulation sheet (30b).

5. The circuit board device according to any one of claim 1 to 3, wherein
the resin portion (20) is electromagnetic wave absorbent resin, and
the sheet (30) is an insulation sheet (30b).

6. The circuit board device according to any one of claim 1 to 5, wherein
the mount board (10) has both sides serving as the mount surface, and
the heat paths (40), the sheets (30), and the resin portions (20) are arranged in both sides of the mount board (10).

7. The circuit board device according to any one of claim 1 to 6, wherein
a line-shaped concave portion (22,31) is formed on a mount surface side face of the sheet (30), and
a part of the lines of the concave portion (22,31) is positioned in the cavity (D).

8. The circuit board device according to any one of claim 1 to 6, wherein
a plurality of domical protrusions (23,33) are formed on the mount surface side face of the sheet.

9. The circuit board device according to any one of claim 1 to 8, wherein
the sheet (30) is an electromagnetic wave absorption sheet (30a), and
an insulation film (32) is formed on a part of the mount surface side face of the sheet the sheet (30) is an electromagnetic wave absorption sheet (30a) that faces a conductor exposure portion (13) of the mount surface.

10. The circuit board device according to any one of claim 1 to 8, wherein
the sheet the sheet (30) is an electromagnetic wave absorption sheet (30a), and
an insulation material (50) is arranged between a portion of the mount surface corresponding to the conductor exposure portion (13) and the sheet the sheet (30) is an electromagnetic wave absorption sheet (30a).

11. The circuit board device according to any one of claim 1 to 8, wherein
the sheet the sheet (30) is an electromagnetic wave absorption sheet includes an electromagnetic wave absorption sheet (30a) and an insulation sheet (30b), and
the insulation sheet (30b) is arranged in a part of the sheet the sheet (30) is an electromagnetic wave absorption sheet (30a) facing the conductor exposure portion (13) of the mount surface.

12. A circuit board device comprising:
a mount board (10) having at least one surface serving as a mount surface of an electronic component (12);
a heat path (40) arranged to a position facing the mount surface; and
a resin portion (20) arranged between the mount board (10) and the heat path (40) while being bonded to the mount surface, the resin portion (20) having a surface facing the mount board (10) and having a shape bondable to the mount surface,
wherein a non-bonding portion (21) is provided in a part of the surface of the resin portion (20) bonded to the mount surface, in which a cavity (D) surrounded by the resin portion (20) and the mount surface is formed on the mount board (10) by separating the resin portion (20) and the mount surface.

13. The circuit board device according to claim 12, wherein
the electronic component (12) mounted on the mount board (10) includes a lateral-projecting type semiconductor package having a terminal protruding from a lateral side, and
the non-bonding portion (21) is provided in a part of a mount surface side face of the resin portion (20) to match a terminal portion of the lateral-projecting type semiconductor package.

14. The circuit board device according to claim 12 or 13, wherein
at least a mount surface side of the resin portion (20) is a non-adhesive surface.

15. The circuit board device according to any one of claim 12 to 14, wherein
a surface of a mount surface side of the resin portion (20) is provided with a line-shaped concave portion (22,31), and
a part of the lines of the concave portion (22,31) is positioned in the cavity (D).

16. The circuit board device according to any one of claim 12 to 15, wherein
a surface of a mount surface side of the resin portion (20) is provided with a plurality of domical protrusions (23,33).

17. The circuit board device according to any one of claim 12 to 16, wherein
both sides of the mount board (10) serve as the mount surfaces, and the heat paths (40) and the resin portions (20) are arranged on both sides.
